# EUROPEAN PATENT APPLICATION

(11) **EP 1 857 575 A2**
(43) Date of publication of application: **21.11.2007**
(21) Application number: 07103276.7
(22) Date of filing: 28.02.2007
(51) Int. Cl.: C30B 29/60, C30B 7/00

(54) **Semiconductor nanocrystal-metal complex and method of preparing the same**

(30) Priority: 16.05.2006 KR 20060043760
(71) Applicant: Samsung Electronics Co., Ltd., Suwon-si, Gyeonggi-Do (KR)
(72) Inventor:
(74) Representative: Kyle, Diana

(57) **Abstract**

Disclosed herein are a semiconductor nanocrystal-metal complex and a method for preparing the same. The semiconductor nanocrystal-metal complex includes a semiconductor nanocrystal and one or more metal particles bound to the semiconductor nanocrystal. The semiconductor nanocrystal-metal complex exhibits excellent photocurrent characteristics and an improved binding force, in addition to the characteristics of semiconductor nanocrystals, thus broadening the applicability of the semiconductor nanocrystal. The semiconductor nanocrystal-metal complex can be at room temperature without involving complicated steps.

## Description

The present invention relates to a semiconductor nanocrystal-metal complex and a method for preparing the complex. More specifically, the present invention relates to a semiconductor nanocrystal-metal complex having a semiconductor nanocrystal and one or more metal particles bound to the surface of the semiconductor nanocrystal, and a method for preparing the semiconductor nanocrystal-metal complex.

A semiconductor nanocrystal (also referred to as a "quantum dot") is defined as a crystalline material having a size on the order of a few nanometers, and includes about several hundred to about several thousand atoms. Since a small-sized semiconductor crystal has a large surface area per unit volume, most of the constituent atoms of the nanocrystal are present on the surface of the nanocrystal. Based on this characteristic structure, a semiconductor nanocrystal exhibits a quantum confinement effect and exhibits electrical, magnetic, optical, chemical and mechanical properties different from those inherent to the constituent atoms of the nanocrystal. That is, control over the physical size of semiconductor nanocrystals enables the control of the properties of the nanocrystals. Devices, such as displays and biological probes, using various characteristics of semiconductor nanocrystals, are currently being developed.

For example, one electronic device, such as a light-emitting diode (LED), includes a semiconductor nanocrystal as a light-emitting material. Further, a process for treating a material using a semiconductor nanocrystal probe includes determining the presence of a biological substance in the material wherein the semiconductor nanocrystal probe is formed by sequentially linking one or more linking agents and one or more affinity molecules to semiconductor nanocrystals.

The basic characteristics of semiconductor nanocrystals lead to limited applicability of existing techniques. In order to utilize these techniques in various analytical applications, such as bioassays, several linking materials must be bound to the surface of semiconductor nanocrystals, which renders the overall process more complicated and results in poor reactivity of the semiconductor nanocrystals.

Therefore, the present invention has been made in view of the above problems, and one aspect of the present invention includes providing a semiconductor nanocrystal-metal complex that can vary the characteristics of a semiconductor nanocrystal and has improved reactivity.

Another aspect of the present invention includes providing a method for preparing a semiconductor nanocrystal-metal complex that can be performed at room temperature without using an additional apparatus or involving any complicated steps.

In accordance with an exemplary embodiment, a semiconductor nanocrystal-metal complex includes a semiconductor nanocrystal and one or more metal particles bound to the semiconductor nanocrystal.

In accordance with another exemplary embodiment, a method for preparing a semiconductor nanocrystal-metal complex includes preparing a semiconductor nanocrystal and mixing the semiconductor nanocrystal with a metal precursor and reducing the metal precursor into metal particles to allow the metal particles to bind to the semiconductor nanocrystal.

The above and other aspects, features, and other advantages of the present invention will be more clearly understood from the following detailed description taken in conjunction with the accompanying drawings, in which:
FIG. 1a is a schematic diagram showing exemplary embodiments of structures of semiconductor nanocrystal-metal complexes of the present invention in which metal particles are bound to a spherical semiconductor nanocrystal;
FIG. 1b is a schematic diagram showing exemplary embodiments of structures of semiconductor nanocrystal-metal complexes of the present invention in which metal particles are bound to a rod-shaped semiconductor nanocrystal;
FIG. 1c is a schematic diagram showing exemplary embodiments of structures of semiconductor nanocrystal-metal complexes of the present invention in which metal particles are bound to semiconductor nanocrystals having tripod and tetrapod shapes;
FIG. 2 is a schematic diagram showing exemplary embodiments of structures of core-shell type semiconductor nanocrystal-metal complexes of the present invention in which metal particles are bound to the surface of a semiconductor nanocrystal to form a layer;
FIG. 3 is a transmission electron microscope (TEM) image of a semiconductor nanocrystal-metal complex prepared in Example 1;
FIG. 4 is a TEM image of a semiconductor nanocrystal-metal complex prepared in Example 2;
FIG. 5a is a scanning transmission electron microscope (STEM) image of the semiconductor nanocrystal-metal complex prepared in Example 2;
FIG. 5b is a graph showing an energy dispersive X-ray spectroscopy (EDS) spectrum of the semiconductor nanocrystal-metal complex prepared in Example 2;
FIG. 6 shows the absorption spectra of a semiconductor nanocrystal solution and a semiconductor nanocrystal-metal complex solution, both of which were prepared in Experimental Example 1;
FIG. 7 shows photoluminescence spectra of a semiconductor nanocrystal solution and a semiconductor nanocrystal-metal complex solution, both of which were prepared in Experimental Example 1; and
FIG. 8 shows absorption spectra of a semiconductor nanocrystal solution and a semiconductor nanocrystal-metal complex solution, both of which were prepared in Experimental Example 2.

Hereinafter the present invention will be described more fully with reference to the accompanying drawings, in which exemplary embodiments of the present invention are shown. This invention may, however, be embodied in many different forms and should not be construed as limited to the exemplary embodiments set forth herein. Rather, these exemplary embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprise", "comprises", and "comprising," when used in this specification, specify the presence of stated features, integers, steps, operations, elements, components, and/or combination of the foregoing, but do not preclude the presence and/or addition of one or more other features, integers, steps, operations, elements, components, groups, and/or combination of the foregoing.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

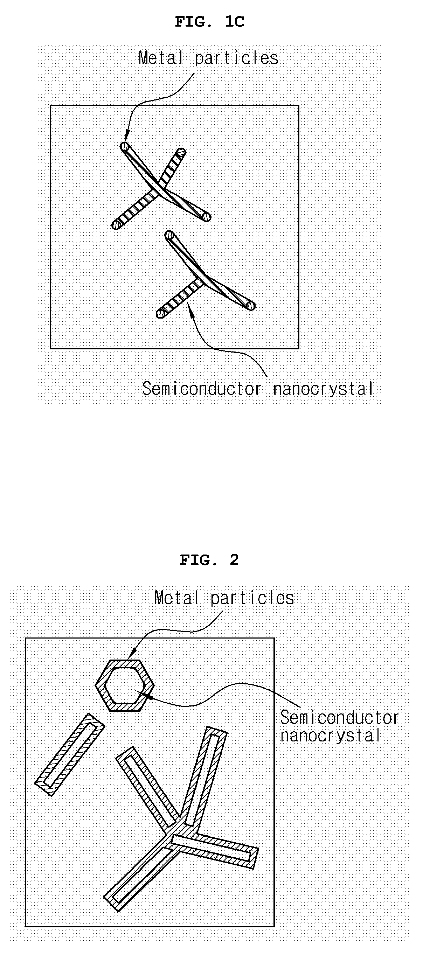

In an exemplary embodiment, the present invention is directed to a semiconductor nanocrystal-metal complex in which metal particles are bound to a semiconductor nanocrystal. More specifically, the semiconductor nanocrystal-metal complex comprises a semiconductor nanocrystal and one or more metal particles bound to the surface of the semiconductor nanocrystal. The metal particles may be directly bound to the surface of the semiconductor nanocrystal. In addition, the semiconductor nanocrystal may have various shapes, including that of a sphere, tetrahedron, cylinder, rod, triangle, disc, tripod, tetrapod, cube, box, star, tube, or the like. The metal particles can be bound to the semiconductor nanocrystal at various positions without restriction. For example, the metal particles may be bound to the edges or ends of the semiconductor nanocrystal. Various exemplary embodiments of structures of semiconductor nanocrystal-metal complexes according to the present invention are shown in FIGS. 1a to 1c.

FIG. 1a is a schematic diagram showing exemplary embodiments of structures of semiconductor nanocrystal-metal complexes in which the semiconductor nanocrystals are spherical. According to the nanocrystal-metal complexes of the embodiments shown in FIG. 1a, one or more metal particles are bound to the surface edges of the spherical semiconductor nanocrystals.

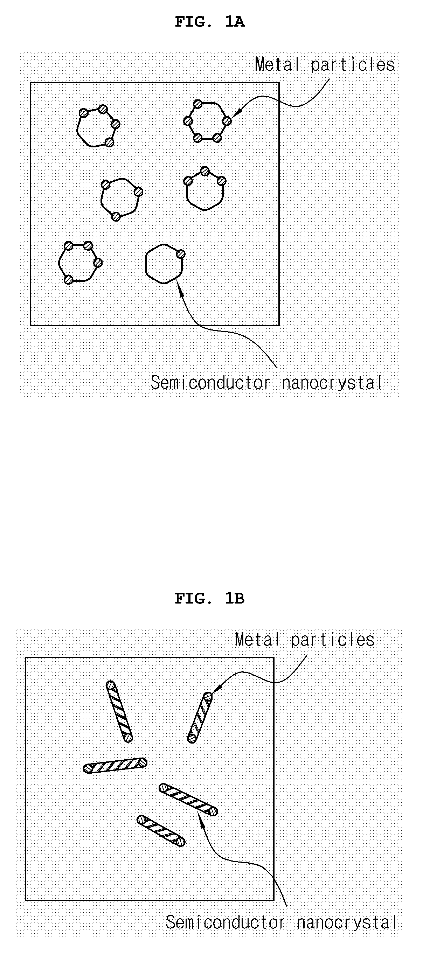

FIG. 1b is a schematic diagram showing exemplary embodiments of structures of semiconductor nanocrystal-metal complexes in which the semiconductor nanocrystals are rod-shaped, and FIG. 1c is a schematic diagram showing exemplary embodiments of structures of semiconductor nanocrystal-metal complexes in which the semiconductor nanocrystals have tripod and tetrapod shapes. With nanocrystal-metal complexes having a dendritic form (i.e. a tripod or tetrapod) according to the embodiments shown in FIG. 1c, metal particles are bound to the ends of the semiconductor nanocrystals.

Continuous reaction of the semiconductor nanocrystal and metal particles allows the metal particles to connect to each other on the surface of the semiconductor nanocrystal, resulting in the formation of a continuous layer surrounding the semiconductor nanocrystal. The semiconductor nanocrystal-metal complex thus prepared can have a core-shell structure.

The structures of exemplary embodiments of core-shell type semiconductor nanocrystal-metal complexes according to the present invention are shown in FIG. 2. According to FIG. 2, the semiconductor nanocrystal-metal complexes include a core formed from the semiconductor nanocrystal having various shapes (including spheres, rods and tetrapods, and the like) and a shell formed from the metal particles to surround the core.

Any semiconductor that exhibits a quantum confinement effect may be used to form the semiconductor nanocrystal of the semiconductor nanocrystal-metal complex. The semiconductor may be selected from the group consisting of Group II-VI, Group III-V, Group IV-VI, and Group IV semiconductor compounds, and mixtures thereof. For example, CdS, CdSe, CdTe, ZnS, ZnSe, ZnTe, HgS, HgSe, HgTe, PbS, PbSe, PbTe, AlN, AlP, AlAs, GaN, GaP, GaAs, InN, InP, InAs, or a mixture thereof can be used to form the semiconductor nanocrystal.

The choice of metal used to make the metal particles is not specifically limited so long as it can be bound to the surface of the nanocrystal. Specifically, the metal can be selected from the group consisting of Au, Ag, Cu, Pt, Pd, Ni, Fe and Co particles.

There is no limitation on the size of the metal particles. The metal particles may be metal nanoparticles having a size of about several nanometers to about several tens of nanometers.

The semiconductor nanocrystal-metal complex of the present invention exhibits excellent photocurrent characteristics, and is easy to prepare even at room temperature without involving complicated steps.

The semiconductor nanocrystal-metal complex of the present invention exhibits both characteristics of the semiconductor nanostructure and characteristics of the metal nanostructure, thus permitting transition of electrons excited to quantized energy levels to the metal nanostructure, which causes a resonance phenomenon to occur. That is, the semiconductor nanocrystal-metal complex of the present invention exhibits new characteristics other than characteristics of the semiconductor nanostructure and the metal nanostructure.

The luminescent properties of the semiconductor nanocrystal-metal complex according to the present invention may disappear or be weakened, unlike those of semiconductor nanocrystals, as determined by photoluminescence spectroscopy. It is assumed that the reason for this disappearance or weakening of the luminescent properties is that less recombination of excitons takes place and instead charge separation occurs within the semiconductor nanocrystal-metal complex, or that Auger recombination of the semiconductor nanocrystal is induced due to the metal structure.

The semiconductor nanocrystal-metal complex of the present invention can be used to manufacture of a variety of devices, (e.g., solar cells, optical sensors, and the like), using photocurrent characteristics.

The metal particles bound to the semiconductor nanocrystal of the semiconductor nanocrystal-metal complex according to the present invention can easily form strong covalent bonds with organic materials having a functional group, thus enabling the application of the semiconductor nanocrystal-metal complex in arrays that can utilize the characteristics of the semiconductor nanocrystal. Therefore, the semiconductor nanocrystal-metal complex of the present invention can find application in various fields, including bioassays.

In an exemplary embodiment, the method for preparing the semiconductor nanocrystal-metal complex comprises preparing a semiconductor nanocrystal and mixing the semiconductor nanocrystal with a metal precursor and reducing the metal precursor into metal particles to allow the metal particles to bind to the semiconductor nanocrystal.

The semiconductor nanocrystal can be synthesized from precursors containing constituent elements of the semiconductor nanocrystal by any synthetic process. For example, the semiconductor nanocrystal can be synthesized by mixing a metal precursor and a chalcogenide precursor in a solvent and a dispersant, and heating the mixture with uniform stirring under an inert atmosphere to react the metal precursor with the chalcogenide precursor. Alternatively, a single compound containing a metal and a chalcogenide element may be added instead of the metal precursor and the chalcogenide precursor. The shape of the semiconductor crystal may be controlled by varying the concentration of the precursors, the reaction temperature, the kind of the dispersant used, and the like.

Examples of metal precursors that can be used in preparing a semiconductor nanocrystal, where a metal precursor and a chalcogenide precursor are used, include, but are not limited to, dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, dimethyl cadmium, diethyl cadmium, cadmium acetate, cadmium acetylacetonate, cadmium iodide, cadmium bromide, cadmium chloride, cadmium fluoride, cadmium carbonate, cadmium nitrate, cadmium oxide, cadmium perchlorate, cadmium phosphide, cadmium sulfate, mercury acetate, mercury iodide, mercury bromide, mercury chloride, mercury fluoride, mercury cyanide, mercury nitrate, mercury oxide, mercury perchlorate, mercury sulfate, lead acetate, lead bromide, lead chloride, lead fluoride, lead oxide, lead perchlorate, lead nitrate, lead sulfate, lead carbonate, tin acetate, tin bisacetylacetonate, tin bromide, tin chloride, tin fluoride, tin oxide, tin sulfate, germanium tetrachloride, germanium oxide, germanium ethoxide, gallium acetylacetonate, gallium chloride, gallium fluoride, gallium oxide, gallium nitrate, gallium sulfate, indium chloride, indium oxide, indium nitrate, and indium sulfate.

Examples of chalcogenide precursors that can be used in preparing the semiconductor nanocrystal, where a metal precursor and a chalcogenide precursor are used, include, but are not limited to, alkanethiol compounds (e.g., hexane thiol, octane thiol, decane thiol, dodecane thiol, hexadecane thiol, octadecane thiol and mercaptopropyl silane), sulfur-trioctylphosphine (S-TOP), sulfur-tributylphosphine (S-TBP), sulfur-triphenylphosphine (S-TPP), sulfur-trioctylamine (S-TOA), trimethylsilyl sulfur, ammonium sulfide, sodium sulfide, selenium-trioctylphosphine (Se-TOP), selenium-tributylphosphine (Se-TBP), selenium-triphenylphosphine (Se-TPP), tellurium-tributylphosphine (Te-TBP), tellurium-triphenylphosphine (Te-TPP), trimethylsilyl phosphine, alkyl phosphines (e.g., triethylphosphine, tributylphosphine, trioctylphosphine, triphenylphosphine, and tricyclohexylphosphine), arsenic oxide, arsenic chloride, arsenic sulfate, arsenic bromide, arsenic iodide, nitric oxide, nitric acid, and ammonium nitrate.

Examples of solvents that can be used in preparing the semiconductor nanocrystal include, but are not limited to: C₆-C₂₂ primary alkyl amines, C₆-C₂₂ secondary alkyl amines and C₆-C₂₂ tertiary alkyl amines; C₆-C₂₂ primary alcohols, C₆-C₂₂ secondary alcohols and C₆-C₂₂ tertiary alcohols; C₆-C₂₂ ketones and esters; C₆-C₂₂ heterocyclic compounds containing at least one nitrogen or sulfur atom; C₆-C₂₂ alkanes, C₆-C₂₂ alkenes and C₆-C₂₂ alkynes; trioctylphosphine; and trioctylphosphine oxide.

Examples of dispersants that can be used in preparing the semiconductor nanocrystal include C₆-C₂₂ alkanes and alkenes having a terminal carboxyl (COOH) group; C₆-C₂₂ alkanes and alkenes having a terminal phosphoryl (POOH) group; C₆-C₂₂ alkanes and alkenes having a terminal sulfhydryl (SOOH) group; and C₆-C₂₂ alkanes and alkenes having a terminal amino (-NH₂) group.

Specifically, as the dispersant, oleic acid, stearic acid, palmitic acid, hexylphosphonic acid, n-octylphosphonic acid, tetradecylphosphonic acid, octadecylphosphonic acid, n-octyl amine, or hexadecyl amine can be used.

In step (b), first, the semiconductor nanocrystal is mixed with a metal precursor. Thereafter, the metal precursor is reduced into metal particles to allow the metal particles to bind to the semiconductor nanocrystal.

The metal precursor used in the mixing step can be prepared by dissolving an organic solvent-soluble organometallic complex containing a metal, which is the same species as the metal of the metal precursor, in a solvent and a dispersant. The metal necessary for the formation of the metal precursor is not particularly limited so long as it can be bound to the surface of the nanocrystal. The metal can be selected from the group consisting of Au, Ag, Cu, Pt, Pd, Ni, Fe, and Co. Examples of suitable organometallic complexes containing the metal include ammonium tetrachloroaurate, hydrogen tetrabromoaurate, hydrogen tetrachloroaurate, potassium dicyanoaurate, potassium tetrabromoaurate, potassium tetrachloroaurate, sodium tetrabromoaurate, di-n-butyltin dilaurate, silver acetate, silver bromide, silver carbonate, silver chloride, silver chromate, silver cyanide, silver cyclohexanebutyrate, silver 2-ethylhexanoate, silver (I) fluoride, silver (II) fluoride, silver hexabromocarborane, silver hexafluoroantimonate, silver hexafluoroarsenate, silver hexafluorophosphate, silver iodide, silver nitrate, silver perchlorate, silver perchlorate monohydrate, silver perrhenate, silver phosphate, silver sulfate, silver telluride, silver tetrafluoroborate, silver thiocyanate, silver trifluoroacetate, silver trifluoromethanesulfonate, silver tungstate, 2,2,6,6-tetramethyl-3,5-heptanedionato silver, trimethylphosphine(hexafluoroacetylacetonato)silver, vinyltriethylsilane(hexafluoroacetylacetonato)silver, bis(N,N'-di-sec-butylacetamidinato)dicopper (Cu), bis(6,6,7,7,8,8,8-heptafluoro-2,2-dimethyl-3,5-octanedionato)copper, bis(2,2,6,6-tetramethyl-3,5-heptanedionato)copper, bis(triphenylphosphine)copper nitrate, bromo(1,10-phenanthroline)(triphenylphosphine)copper, copper (I) acetate, copper (II) acetate, copper (II) acetylacetonate, copper (I) bromide, copper (II) bromide, copper isobutyrate, copper carbonate, copper (I) chloride, copper (II) chloride, copper cyanide, copper cyclohexanebutyrate, copper ethylacetoacetate, copper 2-ethylhexanoate, copper (II) fluoride, copper formate, copper gluconate, copper hexafluoroacetylacetonate, copper hexafluoroacetylacetonate, copper iodide, copper naphthenate, copper neododecanoate, copper nitrate, copper, copper perchlorate, copper phenylacetylide, copper phthalocyanine, copper sulfate, copper tetrafluoroborate (anhydrous), copper (I) thiocyanate, copper (II) trifluoroacetylacetonate, copper (II) trifluoromethanesulfonate, cyclopentadienyl (triethylphosphine)copper, (1,10-phenanthroline)bis(triphenylphosphine)copper nitrate dichloromethane, tetraamine copper sulfate, tetrakis(acetonitrile)copper hexafluorophosphate, trimethylphosphine(hexafluoroacetylacetonato)copper, ammonium hexachloroplatinate, ammonium tetrachloroplatinate, barium tetracyanoplatinate, bis(ethylenediamine)platinum chloride, bis(tri-tert-butylphosphine)platinum, chloroplatinic acid hexahydrate, 1,1-cyclobutanedicarboxylate diamine platinum, diamine platinum nitrite, dibromo(1,5-CyClooctadiene)platinum, dichlorobis(benzonitrile)platinum, cis-dichlorobis(diethylsulfide)platinum, cis-dichlorobis(pyridine)platinum, cis-dichlorobis(triethylphosphine)platinum, cis-dichlorobis(triphenylphosphine)platinum, dichloro(1,5-cyclooctadiene)platinum, dichlorodiamine platinum, di-p-chloro-dichlorobis(ethylene)diplatinum, dichloro (dicyclopentadienyl)platinum, dihydrogen hexahydroxyplatinate, di-p-iodobis(ethylenediamine)diplatinum nitrate, diiodo (1,5-cyclooctadiene)platinum, iodotrimethylplatinum, platinum acetylacetonate, platinum bromide, platinum chloride, platinum cyanide, platinum hexafluoroacetylacetonate, platinum iodide, tetraamine platinum chloride, tetraamine platinum, tetraamine platinum nitrate, tetrachlorodiamine platinum, tetrakis(trifluorophosphine)platinum, (trimethyl)cyclopentadienyl platinum, (trimethyl)methylcyclopentadienyl platinum, potassium bis(oxalato)platinate, potassium hexabromoplatinate, potassium hexachloroplatinate, potassium hexacyanoplatinate, potassium tetrabromoplatinate, potassium tetrachloroplatinate, potassium tetracyanoplatinate, potassium tetranitroplatinate, potassium trichloroamineplatinate, potassium trichloro(ethylene)platinate, sodium hexachloroplatinate hexahydrate, sodium tetrachloroplatinate, allylpalladium chloride dimer, bis(acetato)triphenylphosphine palladium, bis[1,2-bis(diphenylphosphino)ethane]palladium, bis(dibenzylideneacetone)palladium, bis(tri-tert-butylphosphine)palladium, bis(tricyclohexylphosphine)palladium, di(acetato)dicyclohexylphenylphosphine palladium, diamine palladium nitrite, di-bromobis(tri-tert-butylphosphino)dipalladium, dichlorobis(acetonitrile)palladium, dichlorobis(benzonitrile)palladium, dichloro(1,2-bis(diphenylphosphino)ethane)palladium, dichloro(1,3-bis(diphenylphosphino)propane)palladium, *trans-*dichlorobis(tricyclohexylphosphine)palladium, dichlorobis(triphenylphosphine)palladium, *trans-*dichlorobis(tri-o-tolylphosphine)palladium, dichloro(1,5-cyclooctadiene)palladium, *trans*-dichlorodiamine palladium, palladium acetate, palladium acetylacetonate, palladium bromide, palladium chloride, palladium cyanide, palladium iodide, palladium nitrate, palladium trifluoroacetate, tetraamine palladium nitrate, tetraamine palladium tetrachloropalladate, tetrakis(acetonitrile)palladium tetrafluoroborate, tetrakis(triphenylphosphine)palladium, tris(dibenzylideneacetone)dipalladium, bis(1,5-cyclooctadiene)nickel, bis(cyclopentadienyl)nickel, 1,2-bis(diphenylphosphino)ethane nickel chloride, 1,3-bis(diphenylphosphino)propane nickel chloride, bis(ethylcyclopentadienyl)nickel, bis(pentamethylcyclopentadienyl)nickel, bis(isopropylcyclopentadienyl)nickel, bis(tetramethylcyclopentadienyl)nickel, bis(2,2,6,6-tetramethyl-3,5-heptadionato)nickel, bis(triphenylphosphine)nickel bromide, bis(triphenylphosphine)nickel chloride, bis(triphenylphosphine)nickel dicarbonyl, dichloro[1,1'-bis(diphenylphosphino)ferrocene]nickel, hexamine nickel chloride, hexamine nickel iodide, nickel acetate, nickel acetylacetonate, nickel bromide, nickel carbonate, nickel carbonyl, nickel chloride, nickel cyclohexanebutyrate, nickel 2-ethylhexanoate, nickel fluoride, nickel hexafluoroacetylacetonate, nickel hydroxyacetate, nickel iodide, nickel naphthenate, nickel nitrate, nickel oxalate, nickel perchlorate, nickel phthalocyanine, nickel stearate, nickel tetrafluoroborate, nickel thiocyanate, nickel trifluoroacetylacetonate, potassium hexafluoronickelate, potassium tetracyanonickelate hydrate, bis(cyclopentadienyl)cobalt, bis(N,N'-di-*i-*propylacetamidinato)cobalt, cobalt acetate, cobalt acetylacetonate, cobalt bromide, cobalt carbonate, cobalt carbonyl, cobalt chloride, cobalt citrate, cobalt cyclohexanebutyrate, cobalt 2-ethylhexanoate, cobalt fluoride, cobalt iodide, cobalt nitrate, cobalt perchlorate, cobalt phosphate, cobalt phthalocyanine, cobalt stearate, cobalt thiocyanate, cyclopentadienylcobalt dicarbonyl, hexamine cobalt chloride, tetracobalt dodecacarbonyl, potassium hexacyanocobaltate, sodium cobalt carborane, sodium (cyclopentadienyl)tris(dimethylphosphito)cobaltate, sodium hexanitritocobaltate, bis(cyclopentadienyl)iron, bis(ethylcyclopentadienyl)iron, bis(pentamethylcyclopentadienyl)iron, bis(isopropylcyclopentadienyl)iron, bis(tetramethylcyclopentadienyl)iron, cyclohexadiene iron tricarbonyl, iron acetate, iron acetylacetonate, iron bromide, iron chloride, iron dodecacarbonyl, iron fluoride, iron iodide, iron nitrate, iron nonacarbonyl, iron pentacarbonyl, iron perchlorate, iron phthalocyanine, iron isopropoxide, iron stearate, iron tetrafluoroborate, and iron trifluoroacetylacetonate.

The choice of dispersant used for the formation of the metal precursor in the mixing step is not limited, but exemplary dispersants can be selected from the group consisting of oleic acid, stearic acid, palmitic acid, hexylphosphonic acid, n-octylphosphonic acid, tetradecylphosphonic acid, octadecylphosphonic acid, trioctylphosphine, trioctylphosphine oxide, n-octyl amine, hexadecyl amine, hexane thiol, octane thiol, and octadecane thiol.

The reduction of the metal precursor can be achieved by adding the semiconductor nanocrystal solution prepared in the previous step to the metal precursor solution, followed by stirring for a given time. The reaction temperature is not critical. Since the reaction occurs even at room temperature, the semiconductor nanocrystal-metal complex of the present invention can be sufficiently prepared without heating.
In the mixing step of the method according to the present invention, metal particles are bound to the surface of the semiconductor nanocrystal. There is no restriction on where the metal particles can be bound to the semiconductor nanocrystal. For example, the metal particles may be preferentially bound to the sharp edges or ends of the semiconductor nanocrystal, as shown in FIGs. 1a to 1c.

In the mixing step of the method according to the present invention, the concentration and kind of the metal precursor and the reaction temperature are varied so that the metal precursor can be reduced into metal particles in large quantities to form a continuous or discrete layer on the surface of the semiconductor nanocrystal. The semiconductor nanocrystal-metal complex thus prepared comprises a core formed of the semiconductor nanocrystal and a shell formed of the metal particles. Exemplary embodiments of structures of core-shell type semiconductor nanocrystal-metal complexes according to the present invention are shown in FIG. 2.

Hereinafter, the present invention will be explained in more detail with reference to the following examples. However, these examples are given for the purpose of illustration and are not intended to limit the present invention.

### EXAMPLES

### Example 1: Synthesis of spherical semiconductor nanocrystal-metal (CdSeS/Au) complex

About 16 grams (g) of trioctylamine (TOA), about 0.5 g of oleic acid and about 0.4 millimoles (mmol) of cadmium oxide were simultaneously placed in a 100 milliliter (ml) flask equipped with a reflex condenser. The reaction temperature of the mixture was adjusted to about 300 degrees Celsius (°C) with stirring to prepare a cadmium precursor solution. Separately, a selenium (Se) powder was dissolved in trioctylphosphine (TOP) to obtain an approximately 1 molar (M) Se-TOP complex solution, and a sulfur (S) powder was dissolved in TOP to obtain an approximately 0.4 M S-TOP complex solution.

A mixture of about 0.5 ml of the S-TOP complex solution and about 0.5 ml of the Se-TOP complex solution was rapidly fed to the cadmium precursor solution, followed by stirring for about 4 minutes to form a CdSeS nanocrystal or quantum dot (QD).

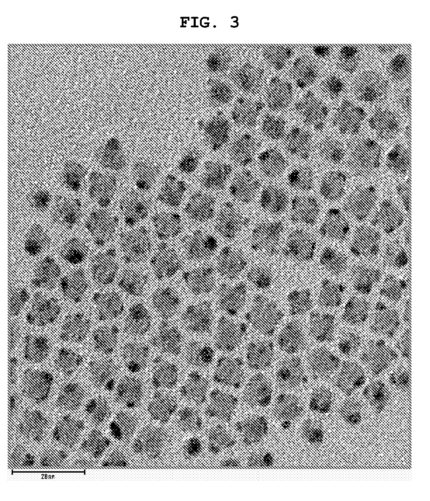

On the other hand, about 0.017 g of hydrogen tetrachloroaurate (HAuCl₄) was dissolved in tetrahydrofuran (THF), and then about 4 ml of oleylamine (OAm) was added thereto to obtain a gold precursor solution. To the gold precursor solution was added about 1 ml of an about 1 weight percent (wt%) solution of the CdSeS nanocrystal in toluene. The resulting mixture was stirred for about 3 hours at room temperature (i.e., about 23°C to about 28°C) to prepare a semiconductor nanocrystal-metal (CdSeS/Au) complex. FIG. 3 shows a transmission electron microscope (TEM) image of the semiconductor nanocrystal-metal (CdSeS/Au) complex. The TEM image demonstrated that one or more metal particles were bound to the surface of the spherical semiconductor nanocrystal.

### Example 2: Synthesis of bar-shaped semiconductor nanocrystal-metal (CdSe/Au) complex

About 2.2 g of trioctylphosphine oxide (TOPO), about 1.07 g of octadecylphosphonic acid and about 0.205 g of cadmium oxide were simultaneously placed in a 100 ml-flask equipped with a reflex condenser. The reaction temperature of the mixture was adjusted to about 330°C with stirring to prepare a cadmium precursor solution. Separately, about 0.063 g of a selenium (Se) powder, about 0.23 ml of tributylphosphine (TBT), about 1.74 ml of TOP and about 0.3 ml of toluene were mixed to obtain a Se complex solution. While the Se complex solution was fed to the cadmium precursor solution, the reaction temperature was lowered to about 280°C. The reaction mixture was stirred for about 6 minutes to form a bar-shaped CdSe nanocrystal.

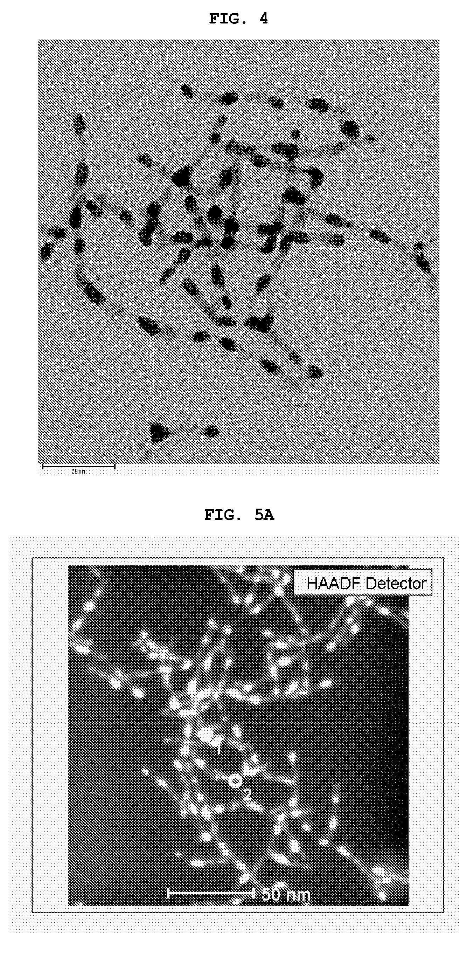

Separately, about 0.017g of hydrogen tetrachloroaurate (HAuCl₄) was dissolved in THF, and then about 4 ml of OAm was added thereto to obtain a gold precursor solution. To the precursor solution was added about 1 ml of an about 1 wt% solution of the CdSe nanocrystal in toluene. The resulting mixture was stirred for about 3 hours at room temperature to prepare a bar-shaped semiconductor nanocrystal-metal (CdSe/Au) complex. FIG. 4 is a TEM image of the semiconductor nanocrystal-metal (CdSe/Au) complex.

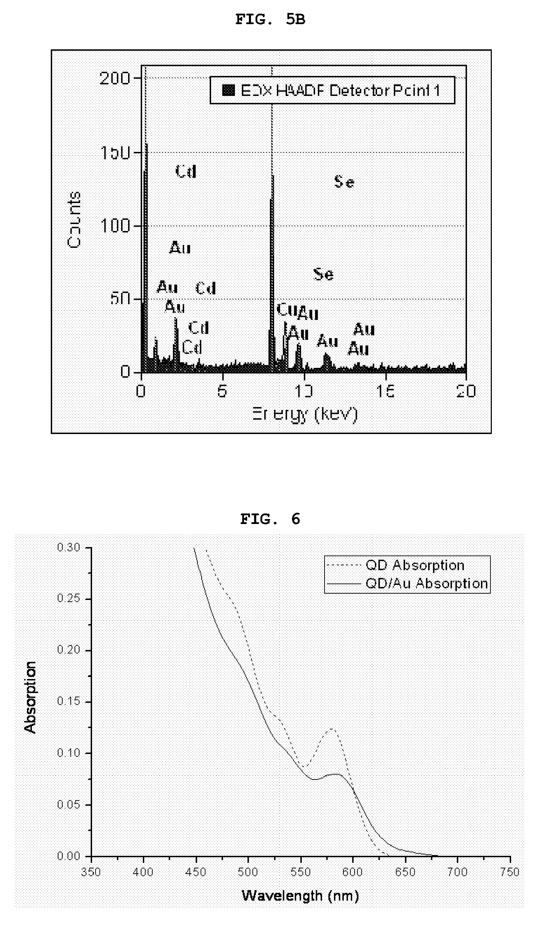

FIG. 5a is a scanning transmission electron microscope (STEM) image of the semiconductor nanocrystal-metal complex, and FIG. 5b is an energy dispersive X-ray spectroscopy (EDS) spectrum of the semiconductor nanocrystal-metal complex. The spectrum of FIG. 5b indicates that Cd, Se and Au elements were detected from the semiconductor nanocrystal-metal complex.

### Experimental Example 1: Evaluation of characteristics of spherical semiconductor nanocrystal-metal complex

The characteristics of the spherical semiconductor nanocrystal-metal complex prepared in Example 1 were evaluated. After the spherical semiconductor nanocrystal-metal complex and the semiconductor nanocrystal quantum dot (QD) prepared in Example 1 were prepared, they were cooled to room temperature as rapidly as possible. Ethanol as a non-solvent was separately added to the nanocrystal-metal complex and the nanocrystal, and the resulting mixtures were centrifuged. The obtained precipitates were separated from the respective supernatants, and dispersed in toluene to prepare an about 1 wt% solution of the CdSeS nanocrystal and an about 1 wt% solution of the semiconductor nanocrystal-metal (CdSeS/Au) complex.

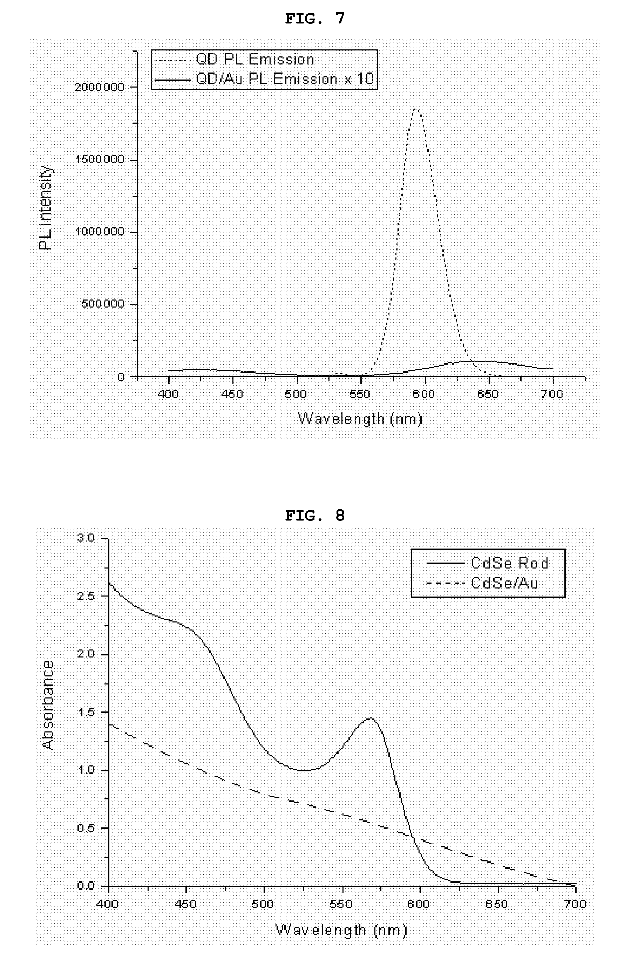

FIGS. 6 and 7 are absorption spectra and photoluminescence spectra of the CdSeS nanocrystal solution and the semiconductor nanocrystal-metal (CdSeS/Au) complex solution, respectively.

These results indicated that the initial absorption peak and the emission peak of the CdSeS semiconductor nanocrystal were observed at wavelengths of about 580 nanometers (nm) and about 598 nm, respectively, whose full-width half maximum (FWHM) was about 30 nm. In contrast, the initial absorption peak of the semiconductor nanocrystal-metal CdSeS/Au complex was observed at a wavelength of 582 nm. The CdSeS/Au complex had a ten-fold higher emission intensity than the CdSeS semiconductor nanocrystal, but exhibited substantially no luminescence properties.

### Experimental Example 2: Evaluation of characteristics of bar-shaped semiconductor nanocrystal-metal complex

The characteristics of the bar-shaped semiconductor nanocrystal-metal complex prepared in Example 2 were evaluated. After the bar-shaped semiconductor nanocrystal-metal complex and the semiconductor nanocrystal prepared in Example 2 were prepared, they were cooled to room temperature as rapidly as possible. Ethanol as a non-solvent was separately added to the nanocrystal-metal complex and the nanocrystal, and the resulting mixtures were centrifuged. The obtained precipitates were separated from the respective supernatants, and dispersed in toluene to prepare an about 1 wt% solution of the CdSe nanocrystal and an about 1 wt% solution of the semiconductor nanocrystal-metal (CdSe/Au) semiconductor complex. FIG. 8 includes absorption spectra of the CdSe nanocrystal solution and the semiconductor nanocrystal-metal (CdSe/Au) complex solution.

These results indicated that the initial absorption peak of the bar-shaped CdSe semiconductor nanocrystal was observed at a wavelength of 570 nm, whereas that of the bar-shaped semiconductor nanocrystal-metal (CdSe/Au) complex was not separated.

As apparent from the foregoing, since the semiconductor nanocrystal-metal complex of the present invention exhibits both characteristics of a semiconductor and characteristics of a metal, it exhibits excellent photocurrent characteristics. Owing to the presence of metal particles bound to the semiconductor nanocrystal, the binding force between the semiconductor nanocrystal and other materials is improved, thus broadening the applicability of the semiconductor nanocrystal.

In addition, the semiconductor nanocrystal-metal complex can be easily prepared even at room temperature without using additional equipment or involving complicated steps.

Although the present invention has been described herein with reference to the foregoing exemplary embodiments, these exemplary embodiments do not serve to limit the scope of the present invention. Accordingly, those skilled in the art to which the present invention pertains will appreciate that various modifications, additions, and substitutions are possible, without departing from the scope and spirit of the invention as disclosed in the accompanying claims.

## Claims

1. A semiconductor nanocrystal-metal complex, comprising a semiconductor nanocrystal and one or more metal particles bound to the semiconductor nanocrystal.

2. The semiconductor nanocrystal-metal complex according to claim 1, wherein the semiconductor nanocrystal has a shape selected from the group consisting of a sphere, tetrahedron, cylinder, rod, triangle, disc, tripod, tetrapod, cube, box, star, and tube.

3. The semiconductor nanocrystal-metal complex according to either claim 1 or 2, wherein the one or more metal particles are bound to a surface of the semiconductor nanocrystal.

4. The semiconductor nanocrystal-metal complex according to any of claims 1 to 3, wherein the one or more metal particles are bound to the edges or ends of the semiconductor nanocrystal.

5. The semiconductor nanocrystal-metal complex according to any of claims 1 to 4, wherein the one or more metal particles surround the semiconductor nanocrystal to form a continuous layer.

6. The semiconductor nanocrystal-metal complex according to any of claims 1 to 5, wherein the semiconductor nanocrystal-metal complex has a core-shell structure comprising a core formed from the semiconductor nanocrystal and a shell formed from the metal particles.

7. The semiconductor nanocrystal-metal complex according to any of claims 1 to 6, wherein the metal particles are metal nanoparticles.

8. The semiconductor nanocrystal-metal complex according to any of claims 1 to 7, wherein the semiconductor nanocrystal comprises a material selected from the group consisting of Group II-VI semiconductor compounds, Group III-V semiconductor compounds, Group IV-VI semiconductor compounds, Group IV semiconductor compounds, and mixtures thereof.

9. The semiconductor nanocrystal-metal complex according to any of claims 1 to 8, wherein the semiconductor nanocrystal comprises a material selected from the group consisting of CdS, CdSe, CdTe, ZnS, ZnSe, ZnTe, HgS, HgSe, HgTe, PbS, PbSe, PbTe, AlN, AlP, AlAs, GaN, GaP, GaAs, InN, InP, InAs, and mixtures thereof.

10. The semiconductor nanocrystal-metal complex according to any of claims 1 to 9, wherein the metal particles are selected from the group consisting of Au, Ag, Cu, Pt, Pd, Ni, Fe, and Co particles.

11. A device comprising the semiconductor nanocrystal-metal complex according to any of claims 1 to 10.

12. A method for preparing a semiconductor nanocrystal-metal complex, the method comprising:
preparing a semiconductor nanocrystal; and
mixing the semiconductor nanocrystal with a metal precursor and reducing the metal precursor into metal particles to bind the metal particles to the semiconductor nanocrystal.

13. The method according to claim 12, wherein the metal particles are bound to a surface of the semiconductor nanocrystal.

14. The method according to either claim 12 or 13, wherein the metal precursor is prepared by dissolving an organic solvent-soluble organometallic complex in a solvent and a dispersant and reacting the solution.

15. The method according to claim 14, wherein the solvent is selected from the group consisting of toluene, chloroform, hexane, oleylamine, trioctylamine, octadecene, and octyl ether.

16. The method according to either claim 14 or 15, wherein the dispersant is selected from the group consisting of oleic acid, stearic acid, palmitic acid, hexylphosphonic acid, n-octylphosphonic acid, tetradecylphosphonic acid, octadecylphosphonic acid, trioctylphosphine, trioctylphosphine oxide, n-octyl amine, hexadecyl amine, hexane thiol, octane thiol, and octadecane thiol.

17. The method according to any of claims 12 to 16, wherein the reducing occurs at room temperature.

18. The method according to any of claims 12 to 17, wherein the metal particles are selected from the group consisting of Au, Ag, Cu, Pt, Pd, Ni, Fe and Co particles.

19. A semiconductor nanocrystal-metal complex prepared by the method according to any of claims 12 to 18.
